# EUROPÄISCHE PATENTANMELDUNG

(11) **EP 3 399 325 A1**
(43) Veröffentlichungstag der Anmeldung: **07.11.2018**
(21) Anmeldenummer: 17169502.6
(22) Anmeldetag: 04.05.2017
(51) Int. Cl.: G01R 33/385, G01R 33/3873, G01R 33/389

(54) **TEMPERIERUNG EINER ZUMINDEST TEILWEISE MAGNETISIERBAREN UMGEBUNG EINER GRADIENTENSPULENEINHEIT**

(71) Anmelder: Siemens Healthcare GmbH, 91052 Erlangen (DE)
(72) Erfinder: Kimmlingen, Ralph, 90513 Zirndorf (DE)

(57) **Zusammenfassung**

Die Erfindung geht aus von einem Verfahren zu einer Temperierung einer zumindest teilweise magnetisierbaren Umgebung einer Gradientenspuleneinheit (wobei die Umgebung beispielsweise passive Shimelemente enthält) eines Magnetresonanzgerätes gemäß den folgenden Verfahrensschritten:
- Erfassen einer ersten Information über eine zeitabhängige Leistungsabgabe der Gradientenspuleneinheit,
- Ermittlung einer prospektiven Temperatur der zumindest teilweise magnetisierbaren Umgebung basierend auf der ersten Information,
- Bestimmung einer Ausgleichstemperatur eines Temperiermediums basierend auf der ermittelten prospektiven Temperatur der zumindest teilweise magnetisierbaren Umgebung, wobei die Ausgleichstemperatur derart bestimmt wird, dass das Temperiermedium mit der Ausgleichstemperatur eine zeitlich stabile Temperatur der zumindest teilweise magnetisierbaren Umgebung bei der zeitabhängigen Leistungsabgabe erzeugt,
- Temperierung der zumindest teilweise magnetisierbaren Umgebung der Gradientenspuleneinheit durch Erzeugung der Ausgleichstemperatur im Temperiermedium.

## Beschreibung

Die Erfindung betrifft ein Verfahren, eine Temperierungseinheit und ein Magnetresonanzgerät zu einer Temperierung einer zumindest teilweise magnetisierbaren Umgebung einer Gradientenspuleneinheit.

In einem Magnetresonanzgerät wird üblicherweise der zu untersuchende Körper eines Untersuchungsobjektes, insbesondere eines Patienten, mit Hilfe eines Hauptmagneten einem relativ hohen Hauptmagnetfeld, beispielsweise von 1,5 oder 3 oder 7 Tesla, ausgesetzt. Zusätzlich werden mit Hilfe einer Gradientenspuleneinheit Gradientenpulse ausgespielt. Über eine Hochfrequenzantenneneinheit werden dann mittels geeigneter Antenneneinrichtungen hochfrequente Hochfrequenz-Pulse, beispielsweise Anregungspulse, ausgesendet, was dazu führt, dass die Kernspins bestimmter, durch diese Hochfrequenz-Pulse resonant angeregter Atome um einen definierten Flipwinkel gegenüber den Magnetfeldlinien des Hauptmagnetfelds verkippt werden. Bei der Relaxation der Kernspins werden Hochfrequenz-Signale, so genannte Magnetresonanz-Signale, abgestrahlt, die mittels geeigneter Hochfrequenzantennen empfangen und dann weiterverarbeitet werden. Aus den so akquirierten Rohdaten können schließlich die gewünschten Bilddaten rekonstruiert werden.

Im Betrieb des Magnetresonanzgerätes ist für eine bestimmte Messung daher eine bestimmte Magnetresonanz-Steuerungssequenz (MR-Steuerungssequenz), auch Pulssequenz genannt, auszusenden, welche aus einer Folge von Hochfrequenz-Pulsen, beispielsweise Anregungspulsen und Refokussierungspulsen, sowie passend dazu koordiniert auszusendenden Gradientenpulsen in verschiedenen Gradientenachsen entlang verschiedener Raumrichtungen besteht. Dabei werden Magnetfeldgradienten zur Ortskodierung erzeugt. Zeitlich passend hierzu werden Auslesefenster gesetzt, welche die Zeiträume vorgeben, in denen die induzierten Magnetresonanz-Signale erfasst werden.

Zum Erzeugen von Gradientenpulsen werden in die Gradientenspulen der Gradientenspuleneinheit Ströme geleitet, deren Amplituden bis zu 1 kA erreichen und die häufigen und raschen Wechseln der Stromrichtung mit Anstiegs- und Abfallraten von mehreren 100 T/m/s unterliegen. Die treibende Spannung für den Spulenstrom beträgt bis zu mehreren kV. Aufgrund ohmscher Verluste, Wirbelstromverluste durch dynamische Streufelder in benachbarten leitfähigen Strukturen und Reibungswärme durch Vibrationen führt dies zu einer Erwärmung. Insbesondere bei gradientenlastigen MR-Steuerungssequenzen, wie sie beispielsweise für die EPI-Diffusion verwendet werden, ist die Erwärmung besonders groß. Die Gradientenspuleneinheit umfasst typischerweise eine Kühleinheit, die das Ausmaß der Erwärmung während des Betriebes der Gradientenspuleneinheit begrenzt und/oder die Temperatur der Gradientenspuleneinheit nach Abschluss der MR-Steuerungssequenz wieder senkt. Die im Betrieb der Gradientenspuleneinheit entstehende Wärme wird auch an die Umgebung der Gradientenspuleneinheit abgegeben, welche dadurch einer Erwärmung ausgesetzt ist. Ebenso kann die Kühlung der Gradientenspuleneinheit eine Senkung der Temperatur der Umgebung der Gradientenspuleneinheit bewirken, jedoch ist die Wirkung der Kühlung auf die Umgebung der Gradientenspuleneinheit im Vergleich zur Wirkung auf die Gradientenspuleneinheit selbst geringer und typischerweise zeitverzögert. Es kann auch ein separate Kühlung für die Umgebung der Gradientenspuleneinheit vorgesehen sein, welche eine Erwärmung der Umgebung typischerweise nicht verhindern kann, jedoch die Umgebung nach der Erwärmung wieder schnell abkühlen kann. Dadurch sind bestimmte Komponenten des Magnetresonanzgerätes in der Umgebung der Gradientenspuleneinheit starken Temperaturänderungen ausgesetzt, was die Haltbarkeit dieser Komponenten beschränken kann und/oder die Akquisition der Rohdaten und die Qualität der zu rekonstruierenden Bilddaten negativ beeinflussen kann.

Der Erfindung liegt die Aufgabe zugrunde, ein Verfahren zu einer besonders effizienten und konstanten Temperierung einer zumindest teilweise magnetisierbaren Umgebung einer Gradientenspuleneinheit anzugeben. Des Weiteren ist es Aufgabe der Erfindung, eine Temperierungseinheit und ein Magnetresonanzgerät, die zur Ausführung des Verfahrens ausgebildet sind, anzugeben. Die Aufgabe wird durch die Merkmale der unabhängigen Ansprüche gelöst. Weitere Ausgestaltungsformen sind in den Unteransprüchen beschrieben.

Das erfindungsgemäße Verfahren zu einer Temperierung einer zumindest teilweise magnetisierbaren Umgebung einer Gradientenspuleneinheit eines Magnetresonanzgerätes sieht die folgenden Verfahrensschritte vor:
- Erfassen einer ersten Information über eine zeitabhängige Leistungsabgabe der Gradientenspuleneinheit,
- Ermittlung einer prospektiven Temperatur der zumindest teilweise magnetisierbaren Umgebung basierend auf der ersten Information,
- Bestimmung einer Ausgleichstemperatur eines Temperiermediums basierend auf der ermittelten prospektiven Temperatur der zumindest teilweise magnetisierbaren Umgebung, wobei die Ausgleichstemperatur derart bestimmt wird, dass das Temperiermedium mit der Ausgleichstemperatur eine zeitlich stabile Temperatur der zumindest teilweise magnetisierbaren Umgebung bei der zeitabhängigen Leistungsabgabe erzeugt,
- Temperierung der zumindest teilweise magnetisierbaren Umgebung der Gradientenspuleneinheit durch Erzeugung der Ausgleichstemperatur im Temperiermedium.

Die Gradientenspuleneinheit ist typischerweise Bestandteil eines Magnetresonanzgerätes, wobei typischerweise eine Hochfrequenzantenneneinheit und ein Hauptmagnet an jeweils einer Seite der Gradientenspuleneinheit anliegen. Der Hauptmagnet umfasst typischerweise ein Kryostat aus Metall. Ebenso können in die Gradientenspuleneinheit Shimelemente integriert sein. Bei der Installation eines Magnetresonanzgerätes wird typischerweise eine Vermessung eines Magnetfeldes des Magnetresonanzgerätes, beispielsweise eines Hauptmagnetfeldes oder eines Magnetfeldgradienten, vorgenommen und basierend auf den Ergebnissen werden Shimelemente, beispielsweise Metall, derart positioniert, dass Abweichungen der Homogenität des Magnetfeldes reduziert werden. Die zumindest teilweise magnetisierbare Umgebung der Gradientenspuleneinheit ist dadurch gekennzeichnet, dass der Betrieb der Gradientenspuleneinheit zu einer Erwärmung der zumindest teilweise magnetisierbaren Umgebung führt, bei Ansteuerung der Gradientenspuleneinheit also Leistung an die zumindest teilweise magnetisierbare Umgebung abgegeben wird. Ebenso ist die zumindest teilweise magnetisierbare Umgebung dadurch gekennzeichnet, dass sie magnetisierbar ist. Typischerweise sind metallische Strukturen im Magnetresonanzgerät einer Magnetisierung ausgesetzt. Beispiele für von der zumindest teilweise magnetisierbaren Umgebung umfasste Komponenten sind Shimelemente und/oder das Kryostat des Hauptmagneten und/oder die Hochfrequenzantenneneinheit.

Bei Ansteuerung der Gradientenspuleneinheit werden Gradientenpulse erzeugt, wobei aufgrund hoher elektrischer Ströme und Widerstand der Gradientenspuleneinheit Leistung abgegeben wird. Diese Leistungsabgabe erfolgt abhängig von den auszuspielenden Gradientenpulsen, welche durch die auszuspielende MR-Steuerungssequenz vorgegeben werden. Die erste Information kann demnach beispielsweise eine Information über die auszuspielende MR-Steuerungssequenz oder die von der auszuspielenden MR-Steuerungssequenz umfassten Gradientenpulse umfassen. Die erste Information kann auch eine mit der auszuspielenden MR-Steuerungssequenz korrelierende zeitabhängige Leistungsabgabe umfassen. Die zeitabhängige Leistungsabgabe entspricht der beim Ausspielen der MR-Steuerungssequenz zeitaufgelöst abzugebenden Leistung. Die abzugebende Leistung wird dabei typischerweise von der Gradientenspuleneinheit an deren Umgebung abgegeben und/oder von der Umgebung der Gradientenspuleneinheit absorbiert.

Die prospektive Temperatur gibt an, wie sich die Temperatur der zumindest teilweise magnetisierbaren Umgebung aufgrund der zeitabhängigen Leistungsabgabe entwickelt und/oder bei der zeitabhängigen Leistungsabgabe entwickeln wird. Die prospektive Temperatur gibt typischerweise eine Änderung der Temperatur der zumindest teilweise magnetisierbaren Umgebung aufgrund der zeitabhängigen Leistungsabgabe an. Die prospektive Temperatur kann auch als absolute Temperatur angegeben werden. Die prospektive Temperatur ist vorzugsweise zeitaufgelöst für zumindest den Zeitraum, während dessen die zeitabhängige Leistungsabgabe erfolgt. Die erste Information kann auch Informationen über mehrere auszuspielende MR-Steuerungssequenzen und optional deren Reihenfolge umfassen, was bei der Ermittlung der prospektiven Temperatur berücksichtigt wird. Die Ermittlung der prospektiven Temperatur erfolgt typischerweise basierend auf einer Berechnung und/oder einer Abschätzung und/oder einer Näherung. Die prospektive Temperatur gibt typischerweise eine zukünftige Temperatur der zumindest teilweise magnetisierbaren Umgebung, sodass diese typischerweise nicht gemessen und/oder experimentell ermittelt werden kann. Die Ermittlung der prospektiven Temperatur ist demnach typischerweise frei von einer Messung und/oder einer experimentellen Bestimmung.

Das Temperiermedium ist typischerweise gasförmig oder flüssig und wird durch eine Leitung an und/oder in die zumindest teilweise magnetisierbare Umgebung geführt. Vorzugsweise umfasst das Temperiermedium Wasser. Die Leitung wird vorzugsweise derart an und/oder durch die zumindest teilweise magnetisierbare Umgebung geführt, dass die zumindest teilweise magnetisierbare Umgebung möglichst effizient die Temperatur des Temperiermediums in der Leitung annimmt.

Die Ausgleichstemperatur ist dadurch gekennzeichnet, dass die Temperatur der zumindest teilweise magnetisierbaren Umgebung bei der zeitabhängigen Leistungsabgabe und im Anschluss daran möglichst konstant ist, also zeitlich stabil ist, wenn das Temperiermedium die Ausgleichstemperatur aufweist. Die Ausgleichstemperatur gibt vorzugsweise eine im Temperiermedium zu erzielende und/oder einzustellende Temperatur an. Die Ausgleichtemperatur ist vorzugsweise zeitabhängig, wird also für einen definierten Zeitraum vorzugsweise zeitaufgelöst bestimmt. Das Temperiermedium kann mittels Heizung und/oder Kühlung auf die Ausgleichstemperatur gebracht werden.

Der Vorteil des erfindungsgemäßen Verfahrens liegt darin, dass die zumindest teilweise magnetisierbare Umgebung der Gradientenspuleneinheit einer möglichst geringen Temperaturänderung ausgesetzt ist. Aufgrund der vorausschauenden Bestimmung der prospektiven Temperatur kann die die zumindest teilweise magnetisierbare Umgebung besonders gut und effizient konstant temperiert werden. Da eine Änderung der Temperatur der zumindest teilweise magnetisierbaren Umgebung die Akquisition der Rohdaten und die Qualität der zu rekonstruierenden Bilddaten negativ beeinflussen kann, kann gemäß dem erfindungsgemäßen Verfahren die Qualität der Bilddaten verbessert werden. Aufgrund der kontinuierlichen Temperierung können Maxima der Erwärmung geschwächt werden und/oder Pausen für eine Abkühlung der zumindest teilweise magnetisierbaren Umgebung vermieden werden. So können mehrere MR-Steuerungssequenzen schneller hintereinander ausgespielt werden, sodass die Dauer einer Untersuchung eines Untersuchungsobjektes verkürzt werden kann. Insbesondere kann auch die Reihenfolge der abzuspielenden MR-Steuerungssequenzen beliebig gewählt werden. Vorzugsweise muss nicht auf eine Stärke der Gradientenpulse und/oder eine Sensitivität einer MR-Steuerungssequenz hinsichtlich einer Änderung der Grundfrequenz bei der Wahl der Reihenfolge der abzuspielenden MR-Steuerungssequenzen berücksichtigt werden.

Ein weiterer Vorteil basiert auf einem Zusammenhang zwischen der Temperatur der zumindest teilweise magnetisierbaren Umgebung und deren Einfluss auf das Hauptmagnetfeld. Es wurde erkannt, dass eine Änderung der Temperatur der zumindest teilweise magnetisierbaren Umgebung deren Magnetisierung beeinflusst. Insbesondere die Magnetisierung eines Shimelementes beeinflusst die Homogenität und/oder die Stärke des Hauptmagnetfeldes. Folglich kann eine Änderung der Temperatur der zumindest teilweise magnetisierbaren Umgebung das Hauptmagnetfeld und/oder einen Magnetfeldgradienten, im Allgemeinen ein vom Magnetresonanzgerät erzeugtes Magnetfeld, verändern. Ein verändertes Magnetfeld wird typischerweise inhomogener, weist also lokale Abweichungen auf. Insbesondere beim Hauptmagnetfeld kann sich die mittlere Stärke innerhalb eines Volumens ändern. Die mittlere Stärke des Hauptmagnetfeldes innerhalb des zentralen Untersuchungsvolumens des Magnetresonanzgerätes kann auch als Grundfrequenz angegeben werden. Die Grundfrequenz entspricht der Larmorfrequenz der Wasserstoffprotonen aufgrund der mittleren Stärke des Hauptmagnetfeldes innerhalb des zentralen Untersuchungsvolumens.

Unabhängig von der auszuspielenden MR-Steuerungssequenz und/oder unabhängig von der zeitabhängigen Leistungsabgabe der Gradientenspuleneinheit ermöglicht das erfindungsgemäße Verfahren eine weitgehend konstante Temperatur der zumindest teilweise magnetisierbaren Umgebung. Dabei wird die Grundfrequenz des Magnetresonanzgerätes unabhängig von der auszuspielenden MR-Steuerungssequenz und/oder unabhängig von der zeitabhängigen Leistungsabgabe der Gradientenspuleneinheit konstant gehalten.

Insbesondere spektroskopische MR-Steuerungssequenzen sind empfindlich hinsichtlich zeitlicher Änderungen der Grundfrequenz und/oder hinsichtlich Änderungen höherer Ordnung des Hauptmagnetfeldes. Wird das erfindungsgemäße Verfahren angewendet, so kann auch eine spektroskopische MR-Steuerungssequenz direkt an eine gradientenlastige MR-Steuerungssequenz, wie beispielsweise eine EPI-Diffusion, anschließen, ohne dass die Aufnahme der Rohdaten und die Qualität der zu rekonstruierenden Bilddaten negativ beeinflusst werden. Gemäß dem erfindungsgemäßen Verfahren kann eine Änderung der Grundfrequenz unabhängig von der auszuspielenden MR-Steuerungssequenz minimiert werden. Die Änderung der Grundfrequenz kann dabei um 80% bis 90% reduziert werden.

Eine Ausführungsform des Verfahrens sieht vor, dass eine zweite Information umfassend eine Temperatur der zumindest teilweise magnetisierbaren Umgebung erfasst wird und die zweite Information bei der Bestimmung der Ausgleichstemperatur berücksichtigt wird. Ist die Temperatur der zumindest teilweise magnetisierbaren Umgebung vor Beginn der zeitabhängigen Leistungsabgabe bekannt, so kann diese auch bei der Ermittlung der prospektiven Temperatur berücksichtigt werden. Dadurch kann die prospektive Temperatur besonders genau ermittelt werden, wodurch auch die Ausgleichstemperatur besonders genau bestimmt werden kann. Die Temperierung der zumindest teilweise magnetisierbaren Umgebung kann dadurch besonders effizient erfolgen.

Eine Ausführungsform des Verfahrens sieht vor, dass eine dritte Information umfassend eine Temperatur des Temperiermediums erfasst wird und die dritte Information bei der Erzeugung der Ausgleichstemperatur im Temperiermedium berücksichtigt wird. Die Ausgleichstemperatur kann dadurch besonders genau erzeugt werden, da eine Differenz der Temperatur des Temperiermediums von der Ausgleichstemperatur bestimmt werden kann und das Temperiermedium um die Differenz gekühlt oder erwärmt werden kann.

Vorzugsweise wird bei der Bestimmung der Ausgleichstemperatur eine Abhängigkeit einer Temperatur der zumindest teilweise magnetisierbaren Umgebung von einer Temperatur des Temperiermediums berücksichtigt. Eine Information umfassend diese Abhängigkeit wird vorzugsweise im Rahmen dieser Ausführungsform des erfindungsgemäßen Verfahrens erfasst und/oder diesem bereitgestellt. Dadurch kann die Wirkung des Temperiermediums auf die zumindest teilweise magnetisierbare Umgebung berücksichtigt werden und die Ausgleichstemperatur besonders genau bestimmt werden.

Eine Ausführungsform des Verfahrens sieht vor, dass eine vierte Information umfassend eine Abhängigkeit einer Temperatur der zumindest teilweise magnetisierbaren Umgebung von einer zeitabhängigen Leistungsabgabe erfasst wird und die vierte Information bei der Ermittlung der prospektiven Temperatur der zumindest teilweise magnetisierbaren Umgebung berücksichtigt wird. Die Abhängigkeit kann mittels eines allgemeinen Algorithmus angegeben werden, welcher eine Änderung der Temperatur der zumindest teilweise magnetisierbaren Umgebung zu einem Gradientenpuls und/oder einer Eigenschaft eines Gradientenpulses verknüpft. Die Abhängigkeit kann auch speziell für die auszuspielende MR-Steuerungssequenz bereitgestellt werden. Gemäß dieser Ausführungsform kann die Wirkung der zeitabhängigen Leistungsabgabe auf die zumindest teilweise magnetisierbare Umgebung berücksichtigt werden und die Ausgleichstemperatur besonders genau bestimmt werden.

Eine Ausführungsform des Verfahrens sieht vor, dass die vierte Information eine Temperaturkonstante der zumindest teilweise magnetisierbaren Umgebung umfasst. Eine Temperaturkonstante quantifiziert insbesondere die Zeitdauer einer Änderung der Temperatur der zumindest teilweise magnetisierbaren Umgebung, beispielsweise abhängig von der Temperatur deren Umgebung, also beispielsweise von der Temperatur des Temperiermediums. Wird die Temperaturkonstante bei der Ermittlung der prospektiven Temperatur und/oder bei der Bestimmung einer Ausgleichstemperatur berücksichtigt, so kann die prospektive Temperatur und/oder die Ausgleichstemperatur besonders vorausschauend und genau bestimmt werden. Dadurch kann eine besonders konstante Temperatur der zumindest teilweise magnetisierbaren Umgebung über einen Zeitraum gewährleistet sein, welcher Zeitraum auch die Dauer der zeitabhängigen Leistungsabgabe der Gradientenspuleneinheit und/oder die Dauer der MR-Steuerungssequenz übersteigen kann.

Eine Ausführungsform des Verfahrens sieht vor, dass die erste Information eine Eigenschaft hinsichtlich der Art der zeitabhängigen Leistungsabgabe umfasst. Die zeitabhängige Leistungsabgabe wird durch eine Aktivität der Gradientenspuleneinheit verursacht, welche Gradientenpulse ausspielt. Die Eigenschaft hinsichtlich der Art der zeitabhängigen Leistungsabgabe kann beispielsweise eine Form der Einhüllenden der Gradientenpulse und/oder deren Anzahl und/oder deren zeitliche Dichte sein. Dadurch können frequenzabhängige Effekte, wie beispielsweise Wirbelströme aufgrund von Streufeldern der Gradientenspuleneinheit durch geeignete Modellparameter berücksichtigt werden. Die Ausgleichstemperatur kann dadurch besonders genau bestimmt werden.

Eine Ausführungsform des Verfahrens sieht vor, dass die Ermittlung der prospektiven Temperatur der zumindest teilweise magnetisierbaren Umgebung eine Tiefpassfilterung der zeitabhängigen Leistungsabgabe umfasst. Eine Tiefpassfilterung der zeitabhängigen Leistungsabgabe entspricht einer zeitlichen Mittelung der zeitabhängigen Leistungsabgabe, wobei beispielsweise die mittlere zeitabhängige Leistungsabgabe für einen Zeitraum von 1s oder von 10s angegeben wird. Nach der Tiefpassfilterung bezieht sich die zeitabhängige Leistungsabgabe typischerweise nicht auf einzelne Pulse, sondern liegt vorzugsweise in der Zeitauflösung vor, mit welcher Zeitauflösung die Ausgleichstemperatur bestimmt und erzeugt wird. Die Tiefpassfilterung bewirkt eine für den weiteren Verfahrensablauf realistische Zeitauflösung, wodurch die Ausgleichstemperatur über einen längeren Zeitraum besonders effizient bestimmt werden kann.

Eine Ausführungsform des Verfahrens sieht vor, dass mittels der Temperierung eine Magnetisierung der zumindest teilweise magnetisierbaren Umgebung der Gradientenspuleneinheit stabilisiert wird. Die Magnetisierung eines magnetisierbaren Materials ist typischerweise temperaturabhängig, sodass eine zeitlich konstante Temperatur aufgrund einer Temperierung zu einer zeitlich konstanten Magnetisierung des magnetisierbaren Materials führt. Ist die zumindest teilweise magnetisierbare Umgebung demnach konstant temperiert, so ist ihre Magnetisierung und damit auch ein von ihr ausgehendes magnetisches Feld konstant. Dies ist in der MR-Bildgebung besonders relevant, da sich unkontrolliert ändernde magnetische Felder die Qualität der Bilddaten negativ beeinflussen.

Eine Ausführungsform des Verfahrens sieht vor, dass mittels der Temperierung ein Hauptmagnetfeld eines Magnetresonanzgerätes umfassend die Gradientenspuleneinheit und einen Hauptmagnet zur Erzeugung des Hauptmagnetfeldes stabilisiert wird, also weitgehend konstant und/oder unverändert gehalten wird. Wird das Hauptmagnetfeld stabilisiert, so weist es insbesondere eine hohe und zeitlich konstante Homogenität und eine zeitlich konstante Grundfrequenz auf. Dies ist in der MR-Bildgebung besonders vorteilhaft, da insbesondere ein Shimdrift vermieden werden kann und/oder Abschattungen in resultierenden Bilddaten aufgrund eines inhomogenen Hauptmagnetfeldes eliminiert werden.

Eine Ausführungsform des Verfahrens sieht vor, dass die Ausgleichstemperatur zeitabhängig bestimmt wird. Eine Ausführungsform des Verfahrens sieht vor, dass die Erzeugung der Ausgleichstemperatur im Temperiermedium zeitabhängig erfolgt.

Des Weiteren geht die Erfindung aus von einer Temperierungseinheit umfassend ein Temperiermedium, eine Temperatursteuereinheit und eine Recheneinheit, welche zu einer Ausführung eines Verfahrens nach einem der vorangehenden Ansprüche zu einer Temperierung einer zumindest teilweise magnetisierbaren Umgebung einer Gradientenspuleneinheit eines Magnetresonanzgerätes ausgelegt ist. Die Recheneinheit ist dazu ausgebildet, die Ausgleichstemperatur im Temperiermedium zu bestimmen und die Temperatursteuereinheit ist dazu ausgebildet, die Ausgleichstemperatur im Temperiermedium zu erzeugen.

Dafür weist die Recheneinheit typischerweise einen Eingang, eine Prozessoreinheit und einen Ausgang auf. Über den Eingang können der Recheneinheit die erste Information und/oder die zweite Information und/oder die dritte Information und/oder die vierte Information und/oder ein Algorithmus zur Ermittlung der prospektiven Temperatur und/oder ein Algorithmus zur Bestimmung einer Ausgleichstemperatur bereitgestellt werden. Weitere, im Verfahren benötigte Funktionen, Algorithmen oder Parameter können der Recheneinheit über den Eingang bereitgestellt werden. Die Ausgleichstemperatur und/oder weitere Ergebnisse einer Ausführungsform des erfindungsgemäßen Verfahrens können über den Ausgang bereitgestellt werden. Die Recheneinheit ist mit der Temperatursteuereinheit über den Ausgang derart verbunden, dass die Temperatursteuereinheit derart angesteuert wird, dass diese die Ausgleichstemperatur im Temperiermedium erzeugen kann.

Die Temperatursteuereinheit ist dazu ausgebildet, das Temperiermedium zu kühlen und/oder zu wärmen. Hierfür umfasst die Temperatursteuereinheit typischerweise einen Wärmetauscher und/oder ein Heizelement. Es sind auch weitere dem Fachmann als sinnvoll erscheinende Ausformungen der Temperatursteuereinheit zur Kühlung und/oder Erwärmung des Temperiermediums denkbar.

Die erfindungsgemäße Temperierungseinheit kann vorzugsweise nachträglich mit bereits in Betrieb genommenen Magnetresonanzgeräten kombiniert und/oder in diese integriert werden.

Eine Ausführungsform der Temperierungseinheit sieht vor, dass die Temperierungseinheit einen ersten Sensor umfasst, welcher mit der Recheneinheit verbunden und dazu ausgebildet ist, die erste Information zu erfassen. Der erste Sensor ist demnach dazu ausgebildet, die zeitabhängige Leistungsabgabe der Gradientenspuleneinheit zu erfassen. Die zeitabhängige Leistungsabgabe kann demnach im Betrieb der Gradientenspuleneinheit erfasst und der Recheneinheit bereitgestellt werden. Die derart erfasste erste Information kann als Kontrolle für eine vor Beginn des Betriebes der Gradientenspuleneinheit erfasste erste Information dienen, so dass die Wirkung der bereits bestimmten Ausgleichstemperatur kontrolliert werden kann und die Ausgleichstemperatur gegebenenfalls mit einer nochmaligen Ausführung des erfindungsgemäßen Verfahrens bestimmt werden kann.

Ebenso kann die derart erfasste erste Information als Grundlage für die Ermittlung der prospektiven Temperatur herangezogen werden, wobei vorzugsweise eine Temperaturkonstante der zumindest teilweise magnetisierbaren Umgebung berücksichtigt wird. Die derart erfasste erste Information spiegelt typischerweise eine aufgrund einer Aktivität der Gradientenspuleneinheit bereits erfolgte Änderung der Temperatur der zumindest teilweise magnetisierbaren Umgebung wider, woraufhin die prospektive Temperatur und die Ausgleichstemperatur ermittelt wird, damit die Temperatur der zumindest teilweise magnetisierbaren Umgebung im weiteren Verlauf der Aktivität der Gradientenspuleneinheit konstant bleibt. Die zeitabhängige Leistungsabgabe aufgrund der Aktivität der Gradientenspuleneinheit kann dabei erst retrospektiv ermittelt werden, sodass das erfindungsgemäße Verfahren reaktionär ausgeführt wird.

Der Vorteil dieser Ausführungsform der Temperierungseinheit besteht darin, dass sie eine Temperierung der zumindest teilweise magnetisierbaren Umgebung ermöglicht, auch wenn die zeitabhängige Leistungsabgabe der Gradientenspuleneinheit beispielsweise im Rahmen einer MR-Steuerungssequenz vorab, insbesondere vor Beginn der MR-Steuerungssequenz, unbekannt ist.

Eine Ausführungsform der Temperierungseinheit sieht vor, dass die Recheneinheit dazu ausgebildet ist, die erste Information basierend auf einer virtuellen Ansteuerung der Gradientenspuleneinheit zu erfassen. Gemäß dieser Ausführungsform wird der Recheneinheit vorzugsweise vor Beginn der MR-Steuerungssequenz eine Information über die Gradientenpulse der MR-Steuerungssequenz bereitgestellt. Die Recheneinheit ist dazu ausgebildet, basierend auf der Information über die Gradientenpulse die mit den Gradientenpulsen verbundene zeitabhängige Leistungsabgabe der Gradientenspuleneinheit zu berechnen. Hierfür erfolgt gemäß dieser Ausführungsform eine virtuelle Ansteuerung der Gradientenspuleneinheit gemäß der MR-Steuerungssequenz, wobei die erste Information ermittelt wird.

Diese Ausführungsform der Temperierungseinheit ermöglicht eine besonders genaue Bestimmung der beim Ausspielen der MR-Steuerungssequenz zu erwartenden zeitabhängigen Leistungsabgabe. Insbesondere ermöglicht diese Ausführungsform eine Bestimmung der ersten Information vor Beginn der Ansteuerung der Gradientenspuleneinheit.

Eine Ausführungsform der Temperierungseinheit sieht vor, dass die Temperierungseinheit einen zweiten Sensor umfasst, welcher mit der Recheneinheit verbunden und dazu ausgebildet ist, eine Temperatur der zumindest teilweise magnetisierbaren Umgebung zu erfassen.

Eine Ausführungsform der Temperierungseinheit sieht vor, dass die Temperierungseinheit einen dritten Sensor umfasst, welcher mit der Recheneinheit verbunden und dazu ausgebildet ist, eine Temperatur des Temperiermediums zu erfassen.

Eine Ausführungsform der Temperierungseinheit sieht vor, dass die Temperatursteuereinheit eine Ventilsteuereinheit umfasst. Die Ventilsteuereinheit ist dazu ausgebildet, einen Fluss des Temperiermediums zu steuern. Umfasst die Temperierungseinheit beispielsweise ein Heizelement und ein Kühlelement, so kann die Ventilsteuereinheit dazu ausgebildet sein, abhängig von der Temperatur des Temperiermediums und abhängig von der Ausgleichstemperatur, das Temperiermedium zumindest teilweise zum Kühlelement und/oder zum Heizelement und/oder direkt zur zumindest teilweise magnetisierbaren Umgebung zu leiten. Dadurch kann die Temperierung besonders energieeffizient erfolgen.

Eine Ausführungsform der Temperierungseinheit sieht vor, dass die Temperatursteuereinheit einen Eingang aufweist, über welchen Eingang der Temperatursteuereinheit eine Abhängigkeit einer Temperatur der zumindest teilweise magnetisierbaren Umgebung von einer Temperatur des Temperiermediums bereitstellbar ist.

Weitere Ausführungsformen der erfindungsgemäßen Temperierungseinheit sind analog zu den Ausführungsformen des erfindungsgemäßen Verfahrens und/oder zu den Ausführungsformen des erfindungsgemäßen Magnetresonanzgerätes ausgebildet und umgekehrt. Die Temperierungseinheit und/oder das Magnetresonanzgerät kann weitere Steuerungskomponenten aufweisen, welche zum Ausführen eines erfindungsgemäßen Verfahrens nötig und/oder vorteilhaft sind. Auch kann die Temperierungseinheit und/oder das Magnetresonanzgerät dazu ausgebildet sein, Steuerungssignale zu senden und/oder Steuerungssignale zu empfangen und/oder zu verarbeiten, um ein erfindungsgemäßes Verfahren auszuführen. Auf einer Speichereinheit der Recheneinheit können Computerprogramme und weitere Software gespeichert sein, mittels derer die Prozessoreinheit der Recheneinheit einen Verfahrensablauf eines erfindungsgemäßen Verfahrens automatisch steuert und/oder ausführt.

Des Weiteren geht die Erfindung aus von einem Magnetresonanzgerät umfassend eine Steuereinheit, eine Gradientenspuleneinheit mit einer zumindest teilweise magnetisierbaren Umgebung, und eine Temperierungseinheit. Die Temperierungseinheit umfasst ein Temperiermedium, eine Temperatursteuereinheit und eine Recheneinheit, welche zu einer Ausführung eines erfindungsgemäßen Verfahrens zu einer Temperierung der zumindest teilweise magnetisierbaren Umgebung der Gradientenspuleneinheit des Magnetresonanzgerätes ausgelegt ist. Die Temperierungseinheit kann in das Magnetresonanzgerät integriert sein. Die Temperierungseinheit kann auch separat von dem Magnetresonanzgerät installiert sein. Die Temperierungseinheit kann mit dem Magnetresonanzgerät verbunden sein.

Eine Ausführungsform des Magnetresonanzgerätes sieht vor, dass bei Ansteuerung der Gradientenspuleneinheit eine Leistungsabgabe an die zumindest teilweise magnetisierbare Umgebung erfolgt. Insbesondere wird die Gradientenspuleneinheit im Betrieb des Magnetresonanzgerätes, also bei Ausspielen einer MR-Steuerungssequenz, gemäß der MR-Steuerungssequenz angesteuert, so dass im Betrieb des Magnetresonanzgerätes eine Leistungsabgabe an die zumindest teilweise magnetisierbare Umgebung erfolgt. Das erfindungsgemäße Verfahren zu einer Temperierung einer zumindest teilweise magnetisierbaren Umgebung der Gradientenspuleneinheit des Magnetresonanzgerätes wird zumindest teilweise im Rahmen des Betriebes des Magnetresonanzgerätes ausgeführt. Die Temperierung wird vorzugsweise zeitabhängig ausgeführt, wobei insbesondere das Erfassen der ersten Information und/oder die Ermittlung der prospektiven Temperatur zumindest teilweise vor Beginn der MR-Steuerungssequenz, also vor Beginn der Ansteuerung der Gradientenspuleneinheit erfolgt.

Die Vorteile des erfindungsgemäßen Magnetresonanzgeräts und der erfindungsgemäßen Temperierungseinheit entsprechen im Wesentlichen den Vorteilen des erfindungsgemäßen Verfahrens zu einer Temperierung der zumindest teilweise magnetisierbaren Umgebung der Gradientenspuleneinheit des Magnetresonanzgerätes, welche vorab im Detail ausgeführt sind. Hierbei erwähnte Merkmale, Vorteile oder alternative Ausführungsformen können ebenso auch auf die anderen beanspruchten Gegenstände übertragen werden und umgekehrt.

Weitere Vorteile, Merkmale und Einzelheiten der Erfindung ergeben sich aus den im Folgenden beschriebenen Ausführungsbeispielen sowie anhand der Zeichnungen.
Es zeigen:
- Fig. 1: eine erste Ausführungsform einer erfindungsgemäßen Temperierungseinheit in einer schematischen Darstellung,
- Fig. 2: eine zweite Ausführungsform einer erfindungsgemäßen Temperierungseinheit in einer schematischen Darstellung,
- Fig. 3: eine dritte Ausführungsform einer erfindungsgemäßen Temperierungseinheit in einer schematischen Darstellung,
- Fig. 4: ein erfindungsgemäßes Magnetresonanzgerät in einer schematischen Darstellung,
- Fig. 5: ein Ablaufdiagramm einer Ausführungsform eines erfindungsgemäßen Verfahrens,
- Fig. 6: eine zeitabhängige Grundfrequenz ohne Anwendung des erfindungsgemäßen Verfahrens, und
- Fig. 7: eine zeitabhängige Grundfrequenz mit Anwendung des erfindungsgemäßen Verfahrens.

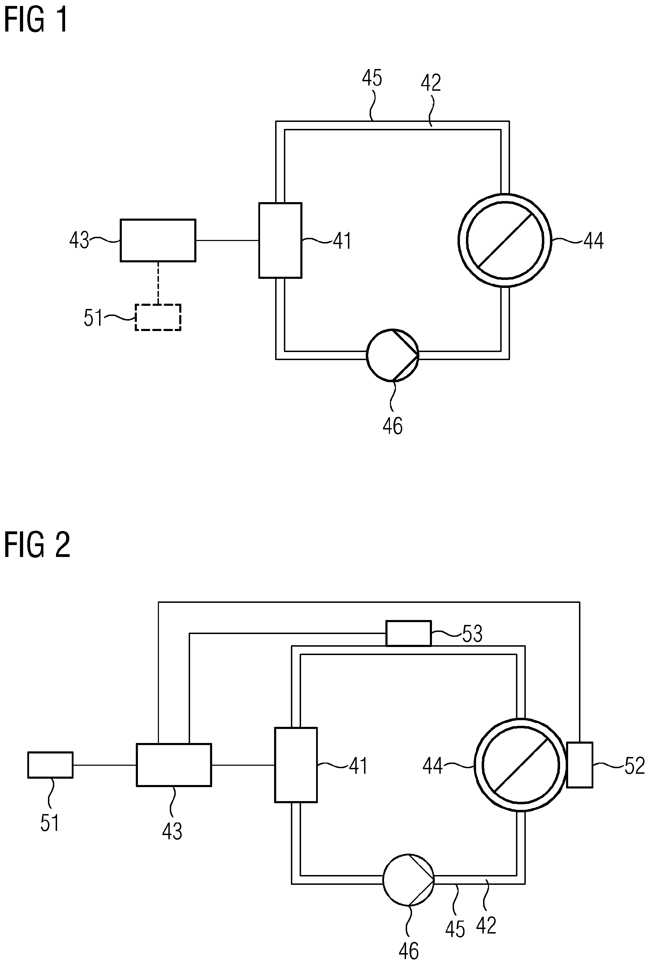

Figur 1 zeigt eine erste Ausführungsform einer erfindungsgemäßen Temperierungseinheit in einer schematischen Darstellung. Die Temperierungseinheit ist zu einer Temperierung einer zumindest teilweise magnetisierbaren Umgebung 44 einer Gradientenspuleneinheit 19 eines Magnetresonanzgerätes 11 ausgelegt. Die Temperierungseinheit umfasst hierfür ein Temperiermedium 42, eine Temperatursteuereinheit 41 und eine Recheneinheit 43. Das Temperiermedium 42 ist von einer Leitung 45 derart umschlossen, dass das Temperiermedium 42 in der Leitung 45 gerichtet geleitet werden kann. Die Leitung 45 kann hierfür einen Temperiermediumrichter 46 umfassen, welcher einen gerichteten Fluss des Temperiermedium 42 von der Temperatursteuereinheit 41 zu der zumindest teilweise magnetisierbaren Umgebung 44 sicherstellt.
Die Leitung 45 ist vorzugsweise derart ausgelegt, dass die Leitung 45 an der zumindest teilweise magnetisierbaren Umgebung 44 und/oder durch diese hindurchführt. Die zumindest teilweise magnetisierbaren Umgebung 44 ist hier als thermische Last dargestellt.

Die Recheneinheit 43 ist dazu ausgebildet, eine Ausgleichstemperatur im Temperiermedium 42 zu bestimmen. Hierfür ermittelt vorzugsweise die Recheneinheit 43 eine prospektive Temperatur der zumindest teilweise magnetisierbaren Umgebung 44 basierend auf einer ersten Information über eine zeitabhängige Leistungsabgabe der Gradientenspuleneinheit 19. Die Recheneinheit 43 kann dazu ausgebildet sein, die erste Information basierend auf einer virtuellen Ansteuerung der Gradientenspuleneinheit 19 zu erfassen. Dabei weist die Recheneinheit 43 vorzugsweise einen Eingang auf, über welchen Eingang der Recheneinheit 43 eine Information zu einer auszuspielenden MR-Steuerungssequenz bereitgestellt wird. Die Recheneinheit 43 ist dabei vorzugsweise mit einer Steuerungseinheit 24 des Magnetresonanzgeräts 11 verbunden. Ebenso kann die Recheneinheit 43 eine Speichereinheit aufweisen, auf der eine Information über die zeitabhängige Leistungsabgabe der auszuspielenden MR-Steuerungssequenz gespeichert ist.
Optional kann die Temperierungseinheit einen ersten Sensor 51 umfassen. Der erste Sensor 51 ist mit der Recheneinheit 43 verbunden und dazu ausgebildet, die erste Information zu erfassen und der Recheneinheit 43 bereitzustellen. Der erste Sensor 51 ist typischerweise an der Gradientenspuleneinheit 19 und/oder an einer elektrischen Zuleitung der Gradientenspuleneinheit 19 angeordnet. Die Temperatursteuereinheit 41 ist dazu ausgebildet, die Ausgleichstemperatur im Temperiermedium 42 zu erzeugen.

Figur 2 zeigt eine zweite Ausführungsform einer erfindungsgemäßen Temperierungseinheit in einer schematischen Darstellung. Zusätzlich zur ersten Ausführungsform der Temperierungseinheit umfasst die Temperierungseinheit einen zweiten Sensor 52 und einen dritten Sensor 53. Die beiden Sensoren 52, 53 können auch einzeln und/oder unabhängig voneinander verwendet werden. Der zweite Sensor 52 ist mit der Recheneinheit 43 verbunden und dazu ausgebildet, eine Temperatur der zumindest teilweise magnetisierbaren Umgebung 44 zu erfassen. Hierfür ist der zweite Sensor 52 typischerweise an und/oder in der zumindest teilweise magnetisierbaren Umgebung 44 angeordnet. Der dritte Sensor 53 ist mit der Recheneinheit 43 verbunden und dazu ausgebildet, eine Temperatur des Temperiermediums 42 zu erfassen. Hierfür ist der dritte Sensor 53 typischerweise an der Leitung 45 und/oder im Temperiermedium 42 angeordnet.

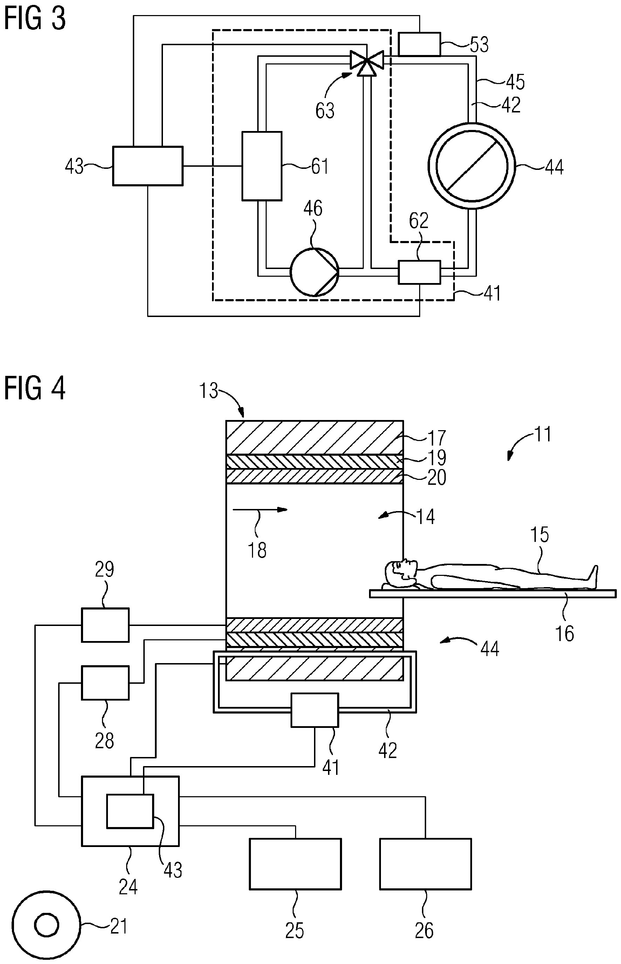

Figur 3 zeigt eine dritte Ausführungsform einer erfindungsgemäßen Temperierungseinheit in einer schematischen Darstellung, wobei eine spezielle Ausführung der Temperatursteuereinheit 41 umfassend eine Ventilsteuereinheit 63 angegeben wird. Die Temperatursteuereinheit 41 umfasst die Ventilsteuereinheit 63, einen Wärmetauscher 61 und ein Heizelement 62. Die Recheneinheit 43 ist mit der Ventilsteuereinheit 63, dem Wärmetauscher 61 und dem Heizelement 62 derart verbunden, dass sie diese ansteuern kann. Der dritte Sensor 53 ist am Rücklauf angeordnet, sodass der dritte Sensor die Temperatur des Temperiermediums 42 nach dessen Durchlauf durch die zumindest teilweise magnetisierbaren Umgebung 44 erfasst. Die Recheineinheit 43 vergleicht die von dem dritten Sensor ermittelte Temperatur des Temperiermediums 42 mit der von der Recheneinheit 43 ermittelten Ausgleichstemperatur. Die Recheneinheit 43 verfügt über derartige Algorithmen, dass die Recheneinheit 43 den Wärmetauscher 61 zur Kühlung des Temperiermediums 42 und/oder das Heizelement 62 zur Erwärmung des Temperiermediums 42 und/oder die Ventilsteuereinheit 63 derart steuern kann, dass beispielsweise möglichst energieeffizient die Ausgleichstemperatur im Temperiermedium 42 im Bereich der zumindest teilweise magnetisierbaren Umgebung 44 erzielt wird. Die Ventilsteuereinheit 63 ist dazu ausgebildet, das Temperiermedium 42 in eine erste Teilmenge und in eine zweite Teilmenge derart zu unterteilen, dass die erste Teilmenge des Temperiermediums 42 durch das Heizelement 62 hindurch oder an dem Heizelement 62 vorbei der zumindest teilweise magnetisierbaren Umgebung 44 zugeführt wird und die zweite Teilmenge zunächst dem Wärmetauscher 61 zugeführt wird.

Figur 4 zeigt ein erfindungsgemäßes Magnetresonanzgerät 11 in einer schematischen Darstellung. Das Magnetresonanzgerät 11 umfasst eine von einer Magneteinheit 13 gebildeten Detektoreinheit mit einem Hauptmagneten 17 zu einem Erzeugen eines starken und insbesondere konstanten Hauptmagnetfelds 18. Zudem weist das Magnetresonanzgerät 11 einen zylinderförmigen Patientenaufnahmebereich 14 zu einer Aufnahme eines Patienten 15 auf, wobei der Patientenaufnahmebereich 14 in einer Umfangsrichtung von der Magneteinheit 13 zylinderförmig umschlossen ist. Der Patient 15 kann mittels einer Patientenlagerungsvorrichtung 16 des Magnetresonanzgeräts 11 in den Patientenaufnahmebereich 14 geschoben werden.

Die Magneteinheit 13 weist weiterhin eine Gradientenspuleneinheit 19 auf, die für eine Ortskodierung während einer Bildgebung verwendet werden. Die Gradientenspuleneinheit 19 wird mittels einer Gradientensteuereinheit 28 angesteuert. Des Weiteren weist die Magneteinheit 13 eine Hochfrequenzantenneneinheit 20, welche im gezeigten Fall als fest in das Magnetresonanzgerät 11 integrierte Körperspule ausgebildet ist, und eine Hochfrequenzantennensteuereinheit 29 zu einer Anregung einer Polarisation, die sich in dem von dem Hauptmagneten 17 erzeugten Hauptmagnetfeld 18 einstellt, auf. Die Hochfrequenzantenneneinheit 20 wird von der Hochfrequenzantennensteuereinheit 29 angesteuert und strahlt hochfrequente Hochfrequenz-Pulse in einen Untersuchungsraum, der im Wesentlichen von dem Patientenaufnahmebereich 14 gebildet ist, ein. In der Umgebung der Gradientenspuleneinheit 19 sind magnetisierbare Komponenten, wie beispielsweise der Hauptmagnet 17 und die Hochfrequenzantenneneinheit 20 angeordnet und/oder weitere Teile der Magneteinheit 13, angeordnet, welche die zumindest teilweise magnetisierbare Umgebung 44 der Gradientenspuleneinheit 19 bilden. Ebenso kann die zumindest teilweise magnetisierbare Umgebung 44 der Gradientenspuleneinheit 19 ein Shimelement umfassen, welches Shimelement in einem Bereich angeordnet ist, welcher Bereich von der Gradientenspuleneinheit 19 und/oder dem Hauptmagnet 17 und/oder von der Hochfrequenzantenneneinheit 20 gebildet wird.

Zu einer Steuerung des Hauptmagneten 17, der Gradientensteuereinheit 28 und der Hochfrequenzantennensteuereinheit 29 weist das Magnetresonanzgerät 11 eine Steuerungseinheit 24 auf. Die Steuerungseinheit 24 steuert zentral das Magnetresonanzgerät 11, wie beispielsweise das Durchführen von MR-Steuerungssequenzen. Das Magnetresonanzgerät 11 weist eine Anzeigeeinheit 25 auf. Steuerinformationen wie beispielsweise Steuerungsparameter, sowie rekonstruierte Bilddaten können auf der Anzeigeeinheit 25, beispielsweise auf zumindest einem Monitor, für einen Benutzer angezeigt werden. Zudem weist das Magnetresonanzgerät 11 eine Eingabeeinheit 26 auf, mittels derer Informationen und/oder Steuerungsparameter während eines Messvorgangs von einem Benutzer eingegeben werden können. Die Steuerungseinheit 24 kann die Gradientensteuereinheit 28 und/oder Hochfrequenzantennensteuereinheit 29 und/oder die Anzeigeeinheit 25 und/oder die Eingabeeinheit 26 umfassen.

Das Magnetresonanzgerät 11 umfasst weiterhin eine Recheneinheit 43, eine Temperatursteuereinheit 41 und ein Temperiermedium 42. Die Recheneinheit 43, die Temperatursteuereinheit 41 und das Temperiermedium 42 bilden zusammen eine erfindungsgemäße Temperierungseinheit. Dabei ist die Recheneinheit 43 mit der Steuerungseinheit 24 verbunden und/oder in diese integriert. Die Recheneinheit 43 ist zusätzlich mit der Temperatursteuereinheit 41 verbunden.
Die Recheneinheit 43 ist dazu ausgebildet, die Ausgleichstemperatur im Temperiermedium 42 zu bestimmen. Die Temperatursteuereinheit 41 ist dazu ausgebildet, die Ausgleichstemperatur im Temperiermedium 42 zu erzeugen. Hierzu weist die Recheneinheit 43 Computerprogramme und/oder Software auf, die direkt in einem nicht näher dargestellten Speichereinheit der Recheneinheit 43 ladbar sind, mit Programmmitteln, um ein Verfahren zu einer Temperierung der zumindest teilweise magnetisierbaren Umgebung 44 der Gradientenspuleneinheit 19 auszuführen, wenn die Computerprogramme und/oder Software in der Recheneinheit 43 ausgeführt werden. Die Recheneinheit 43 weist hierzu einen nicht näher dargestellten Prozessor auf, der zu einer Ausführung der Computerprogramme und/oder Software ausgelegt ist. Alternativ hierzu können die Computerprogramme und/oder Software auch auf einem getrennt von der Steuerungseinheit 24 und/oder Recheneinheit 43 ausgebildeten elektronisch lesbaren Datenträger 21 gespeichert sein, wobei ein Datenzugriff von der Recheneinheit 43 auf den elektronisch lesbaren Datenträger 21 über ein Datennetz erfolgen kann.

Das dargestellte Magnetresonanzgerät 11 kann selbstverständlich weitere Komponenten umfassen, die Magnetresonanzgeräte 11 gewöhnlich aufweisen. Eine allgemeine Funktionsweise eines Magnetresonanzgeräts 11 ist zudem dem Fachmann bekannt, so dass auf eine detaillierte Beschreibung der weiteren Komponenten verzichtet wird.

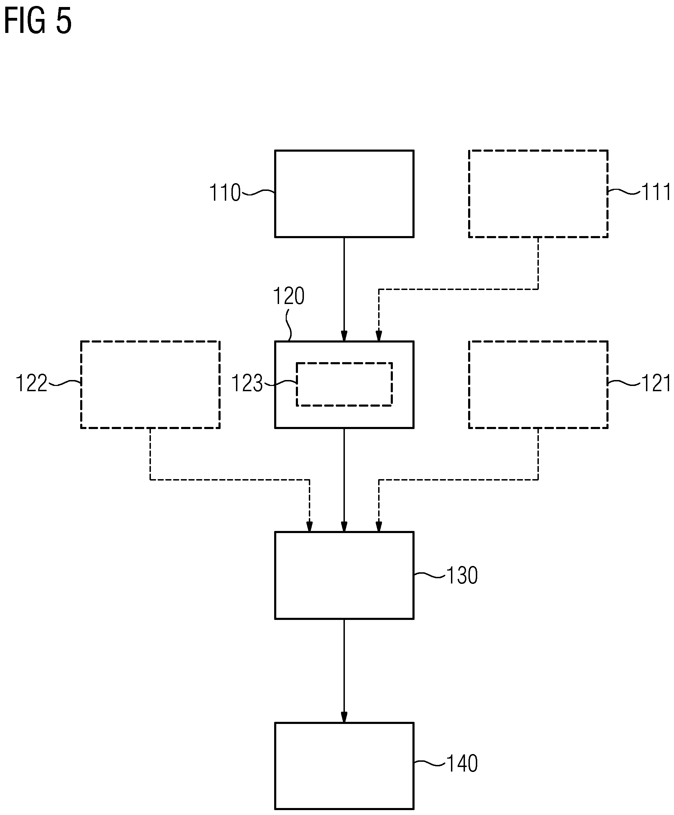

Figur 5 zeigt ein Ablaufdiagramm einer Ausführungsform eines erfindungsgemäßen Verfahrens zu einer Temperierung einer zumindest teilweise magnetisierbaren Umgebung 44 einer Gradientenspuleneinheit 19 eines Magnetresonanzgerätes 11. Dabei wird in Verfahrensschritt 110 eine erste Information über eine zeitabhängige Leistungsabgabe der Gradientenspuleneinheit 19 erfasst. So kann beispielsweise in Verfahrensschritt 110 der zeitliche Verlauf des Leistungseintrages bzw. Wärmeeintrages aufgrund eines Betriebes der Gradientenspuleneinheit 19, also aufgrund einer Ansteuerung der Gradientenspuleneinheit 19 gemäß Vorgaben einer MR-Steuerungssequenz, vor dem Start der MR-Steuerungssequenz berechnet werden und/oder während dem Ausspielen der MR-Steuerungssequenz, also während des Betriebes der Gradientenspuleneinheit 19, gemessen werden. Die erste Information kann dabei eine Eigenschaft hinsichtlich der Art der zeitabhängigen Leistungsabgabe umfassen. Dies können beispielsweise frequenzabhängige Effekte wie Wirbelstromeffekte durch Streufelder der mittels der Gradientenspuleneinheit 19 erzeugten Magnetfeldgradienten sein.

Basierend auf der ersten Information wird in Verfahrensschritt 120 eine prospektive Temperatur der zumindest teilweise magnetisierbaren Umgebung 44 ermittelt. Dabei kann eine von der ersten Information umfasste Eigenschaft mittels geeigneter Modellparameter berücksichtigt werden. Optional kann Verfahrensschritt 120 Verfahrensschritt 123, eine Tiefpassfilterung der zeitabhängigen Leistungsabgabe umfassen. Parameter für die Tiefpassfilterung können beispielsweise mittels einer einmaligen Kalibrationsmessung im Rahmen des erfindungsgemäßen Verfahrens bestimmt werden und/oder dem erfindungsgemäßen Verfahren bereitgestellt werden, indem die Parameter auf einer Speichereinheit hinterlegt sind. Dadurch kann berücksichtigt werden, dass aufgrund thermischer Widerstände und/oder Kapazitäten der zumindest teilweise magnetisierbaren Umgebung 44 eine zeitliche Verzögerung zwischen der zeitabhängigen Leistungsabgabe und einer Änderung der Temperatur und/oder einer Änderung der Magnetisierung der zumindest teilweise magnetisierbaren Umgebung 44 auftreten kann.

Basierend auf der in Verfahrensschritt 120 ermittelten prospektiven Temperatur wird in Verfahrensschritt 130 anschließend eine Ausgleichstemperatur des Temperiermediums 42 derart bestimmt, dass das Temperiermedium 42 mit der Ausgleichstemperatur eine zeitlich stabile Temperatur der zumindest teilweise magnetisierbaren Umgebung 44 bei der zeitabhängigen Leistungsabgabe erzeugt. In Verfahrensschritt 140 erfolgt schließlich die Temperierung der zumindest teilweise magnetisierbaren Umgebung 44 der Gradientenspuleneinheit 19 durch Erzeugung der Ausgleichstemperatur im Temperiermedium 42. Für die Erzeugung der Ausgleichstemperatur im Temperiermedium 42 ist vorzugsweise die Temperatur des Temperiermediums 42 im Vorlauf der Gradientenspuleneinheit 19 bekannt, sodass die Ausgleichstemperatur im Temperiermedium 42 typischerweise mittels eines Kühlelementes und/oder mittels eines Heizelementes eingestellt werden kann. Die Temperatur des Temperiermediums 42 im Vorlauf der Gradientenspuleneinheit 19 kann mittels einer Kalibrationsmessung, beispielsweise durch das Ausspielen einer MR-Steuerungssequenz mit einer mittleren zeitabhängigen Leistungsabgabe, bestimmt werden. Dadurch kann eine Magnetisierung der zumindest teilweise magnetisierbaren Umgebung 44 der Gradientenspuleneinheit 19 stabilisiert werden, wodurch vorzugsweise auch das Hauptmagnetfeld 18 des Magnetresonanzgerätes 11 stabilisiert wird.

Optional wird in Verfahrensschritt 111 eine vierte Information umfassend eine Abhängigkeit einer Temperatur der zumindest teilweise magnetisierbaren Umgebung 44 von einer Temperatur des Temperiermediums 42 erfasst, welche vierte Information in Verfahrensschritt 120 bei der Ermittlung der prospektiven Temperatur der zumindest teilweise magnetisierbaren Umgebung 44 berücksichtigt wird. Die vierte Information kann dabei eine Temperaturkonstante der zumindest teilweise magnetisierbaren Umgebung 44 umfassen. Optional wird in Verfahrensschritt 121 eine zweite Information umfassend eine Temperatur der zumindest teilweise magnetisierbaren Umgebung 44 erfasst, welche zweite Information bei der Bestimmung der Ausgleichstemperatur in Verfahrensschritt 130 berücksichtigt wird. Ebenso kann optional in Verfahrensschritt 122 eine dritte Information umfassend eine Temperatur des Temperiermediums 42 erfasst werden, welche dritte Information bei der der Erzeugung der Ausgleichstemperatur im Temperiermedium 42 berücksichtigt wird.

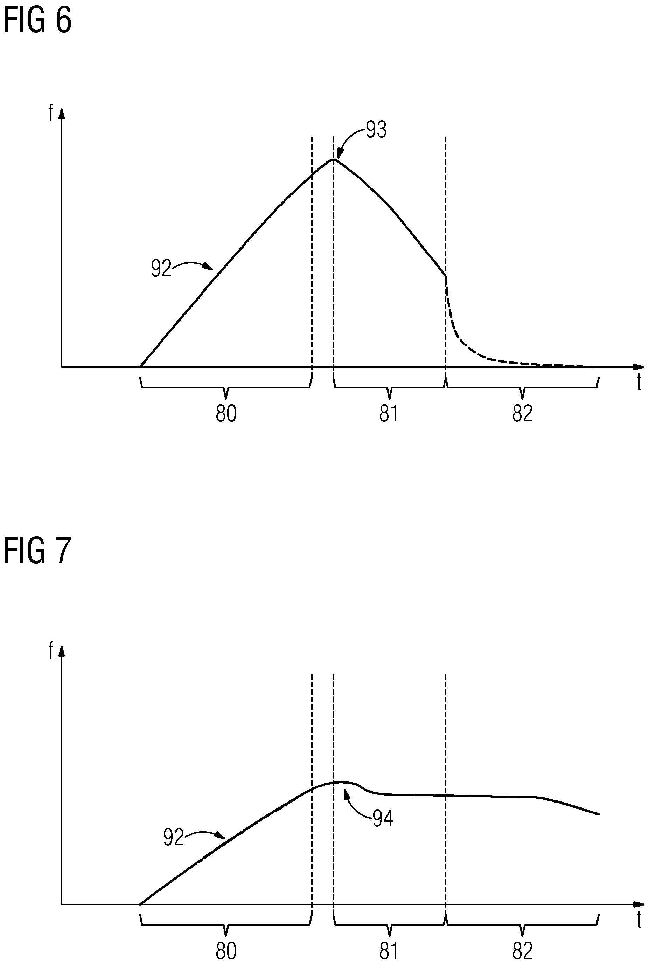

Das Diagramm in Figur 6 visualisiert einen ersten Fall einer zeitabhängigen Grundfrequenz f ohne Anwendung des erfindungsgemäßen Verfahrens, das Diagramm in Figur 7 visualisiert einen zweiten Fall einer zeitabhängigen Grundfrequenz f mit Anwendung des erfindungsgemäßen Verfahrens. Die Ursache für die Änderung der Grundfrequenz f ist im ersten Fall und im zweiten Fall eine identische Aktivität der Gradientenspuleneinheit 19 im Zeitraum 80, die jeweils zu einem Anstieg 91, 92 der Grundfrequenz f führt. Der Anstieg 91 der Grundfrequenz f im ersten Fall ist stärker als der Anstieg 92 der Grundfrequenz f im zweiten Fall, da gemäß dem erfindungsgemäßen Verfahren die Ausgleichstemperatur zeitabhängig bestimmt werden kann und zu Beginn des Zeitraumes 80 die zumindest teilweise magnetisierbare Umgebung 44 beispielsweise bereits vorgewärmt wird und/oder wurde, sodass eine Erwärmung und damit eine Erhöhung der Grundfrequenz f aufgrund der zeitabhängigen Leistungsabgabe geringer ist. Nach Ende des Zeitraumes 80 erwärmt sich die zumindest teilweise magnetisierbare Umgebung 44 im ersten Fall und im zweiten Fall zunächst weiter und die Grundfrequenz f erreicht zeitverzögert ein erstes Maximum 93 im ersten Fall und ein zweites Maximum 94 im zweiten Fall aufgrund von Zeitkonstanten der zumindest teilweise magnetisierbaren Umgebung 44. Der Zeitpunkt des ersten Maximums kann sich von Zeitpunkt des zweiten Maximums unterschieden.

Im ersten Fall sinkt die Grundfrequenz f nach dem ersten Maximum 93 stärker als im zweiten Fall nach dem zweiten Maximum 94. Im ersten Fall bewirkt im Zeitraum 81 eine indirekte Kühlung, eine Reduktion der Magnetisierung der zumindest teilweise magnetisierbaren Umgebung 44, indem das Kühlmedium 42 über einen Bypass geführt wird. Im darauffolgenden Zeitraum 82 sinkt die Grundfrequenz f exponentiell aufgrund direkter und aktiver Kühlung. Im zweiten Fall wird die zeitabhängige Ausgleichstemperatur hingegen derart gewählt, dass die Grundfrequenz f in den Zeiträumen 81 und 82 nach dem zweiten Maximum 94 näherungsweise konstant bleibt. Eine Erhöhung der Temperatur der zumindest teilweise magnetisierbaren Umgebung 44 kann auch eine Reduktion der Grundfrequenz f bewirken. In diesem Fall würden die Diagramme der Figuren 6 und 7 horizontal gespiegelt dargestellt werden.

Obwohl die Erfindung im Detail durch die bevorzugten Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren zu einer Temperierung einer zumindest teilweise magnetisierbaren Umgebung einer Gradientenspuleneinheit eines Magnetresonanzgerätes gemäß den folgenden Verfahrensschritten:
- Erfassen einer ersten Information über eine zeitabhängige Leistungsabgabe der Gradientenspuleneinheit,
- Ermittlung einer prospektiven Temperatur der zumindest teilweise magnetisierbaren Umgebung basierend auf der ersten Information,
- Bestimmung einer Ausgleichstemperatur eines Temperiermediums basierend auf der ermittelten prospektiven Temperatur der zumindest teilweise magnetisierbaren Umgebung, wobei die Ausgleichstemperatur derart bestimmt wird, dass das Temperiermedium mit der Ausgleichstemperatur eine zeitlich stabile Temperatur der zumindest teilweise magnetisierbaren Umgebung bei der zeitabhängigen Leistungsabgabe erzeugt,
- Temperierung der zumindest teilweise magnetisierbaren Umgebung der Gradientenspuleneinheit durch Erzeugung der Ausgleichstemperatur im Temperiermedium.

2. Verfahren nach Anspruch 1,
wobei eine zweite Information umfassend eine Temperatur der zumindest teilweise magnetisierbaren Umgebung erfasst wird und die zweite Information bei der Bestimmung der Ausgleichstemperatur berücksichtigt wird.

3. Verfahren nach einem der vorangehenden Ansprüche,
wobei eine dritte Information umfassend eine Temperatur des Temperiermediums erfasst wird und die dritte Information bei der Erzeugung der Ausgleichstemperatur im Temperiermedium berücksichtigt wird.

4. Verfahren nach einem der vorangehenden Ansprüche,
wobei eine vierte Information umfassend eine Abhängigkeit einer Temperatur der zumindest teilweise magnetisierbaren Umgebung von einer Temperatur des Temperiermediums erfasst wird und die vierte Information bei der Ermittlung der prospektiven Temperatur der zumindest teilweise magnetisierbaren Umgebung berücksichtigt wird.

5. Verfahren nach Anspruch 4,
wobei die vierte Information eine Temperaturkonstante der zumindest teilweise magnetisierbaren Umgebung umfasst.

6. Verfahren nach einem der vorangehenden Ansprüche,
wobei die erste Information eine Eigenschaft hinsichtlich der Art der zeitabhängigen Leistungsabgabe umfasst.

7. Verfahren nach einem der vorangehenden Ansprüche,
wobei die Ermittlung der prospektiven Temperatur der zumindest teilweise magnetisierbaren Umgebung eine Tiefpassfilterung der zeitabhängigen Leistungsabgabe umfasst.

8. Verfahren nach einem der vorangehenden Ansprüche,
wobei mittels der Temperierung eine Magnetisierung der zumindest teilweise magnetisierbaren Umgebung der Gradientenspuleneinheit stabilisiert wird.

9. Verfahren nach einem der vorangehenden Ansprüche,
wobei mittels der Temperierung ein Hauptmagnetfeld eines Magnetresonanzgerätes umfassend die Gradientenspuleneinheit und einen Hauptmagnet zur Erzeugung des Hauptmagnetfeldes stabilisiert wird.

10. Temperierungseinheit umfassend ein Temperiermedium, eine Temperatursteuereinheit und eine Recheneinheit, welche zu einer Ausführung eines Verfahrens nach einem der vorangehenden Ansprüche zu einer Temperierung einer zumindest teilweise magnetisierbaren Umgebung einer Gradientenspuleneinheit eines Magnetresonanzgerätes ausgelegt ist,
wobei die Recheneinheit dazu ausgebildet ist, die Ausgleichstemperatur im Temperiermedium zu bestimmen und
die Temperatursteuereinheit dazu ausgebildet ist, die Ausgleichstemperatur im Temperiermedium zu erzeugen.

11. Temperierungseinheit nach Anspruch 10,
wobei die Temperierungseinheit einen ersten Sensor umfasst, welcher mit der Recheneinheit verbunden und dazu ausgebildet ist, die erste Information zu erfassen.

12. Temperierungseinheit nach einem der Ansprüche 10 bis 11, wobei die Recheneinheit dazu ausgebildet ist, die erste Information basierend auf einer virtuellen Ansteuerung der Gradientenspuleneinheit zu erfassen.

13. Temperierungseinheit nach einem der Ansprüche 10 bis 12, wobei die Temperierungseinheit einen zweiten Sensor umfasst, welcher mit der Recheneinheit verbunden und dazu ausgebildet ist, eine Temperatur der zumindest teilweise magnetisierbaren Umgebung zu erfassen.

14. Temperierungseinheit nach einem der Ansprüche 10 bis 13, wobei die Temperierungseinheit einen dritten Sensor umfasst, welcher mit der Recheneinheit verbunden und dazu ausgebildet ist, eine Temperatur des Temperiermediums zu erfassen.

15. Temperierungseinheit nach einem der Ansprüche 10 bis 14, wobei die Temperatursteuereinheit eine Ventilsteuereinheit umfasst.

16. Magnetresonanzgerät umfassend eine Temperierungseinheit nach einem der Ansprüche 10 bis 15 und eine Gradientenspuleneinheit mit einer zumindest teilweise magnetisierbaren Umgebung.
